# EUROPÄISCHE PATENTSCHRIFT

(11) **EP 1 384 263 B1**
(45) Veröffentlichungstag und Bekanntmachung des Hinweises auf die Patenterteilung: **30.03.2005**
(21) Anmeldenummer: 02735294.7
(22) Anmeldetag: 23.04.2002
(51) Int. Cl.: H01L 23/495

(54) **TRÄGER FÜR ELEKTRISCHE SCHALTUNGSELEMENTE**
SUPPORT FOR ELECTRICAL CIRCUIT ELEMENTS
SUPPORT POUR ELEMENTS DE CIRCUIT ELECTRIQUES

(30) Priorität: 23.04.2001 DE 10119848
(43) Veröffentlichungstag der Anmeldung: 28.01.2004
(73) Patentinhaber: FRAUNHOFER-GESELLSCHAFT ZUR FÖRDERUNG DER ANGEWANDTEN FORSCHUNG E.V., 80636 München (DE); Possehl Electronics Deutschland GmbH, 22880 Wedel (DE)
(72) Erfinder: LÜTHJE, Holger, 25469 Halstenbeck (DE); KLAGES, Claus-Peter, 38102 Braunschweig (DE); VAN DER ZANDEN, Johannes Theodorus Maria, 5233 RL's-Hertogenbosch (NL); THIELE, Arno, 58809 Neuenrade (DE)
(74) Vertreter: Pfenning, Meinig & Partner
(86) Internationale Anmeldenummer: PCT/EP2002/004497
(87) Internationale Veröffentlichungsnummer: WO 2002/087293

(56) Entgegenhaltungen:
- US-A- 5 138 431
- US-A- 5 360 991
- US-A- 5 709 957

## Beschreibung

Die Erfindung betrifft einen Träger nach dem Oberbegriff des Anspruchs 1. Ein derartiger Träger kann einer Leiterrahmen (Lead Frame), auf welchem Halbleiterchips befestigt werden, oder auch eine mit Leiterbahnen versehene Schaltungsplatte oder flexible Folie sein.

Halbleiterbauelemente bestehen z.B. aus einer integrierten Schaltung, dem sogenannten Chips, und einem Leiterrahmen als Träger für dieses, der eine Fläche zur Aufnahme des Chips und eine Vielzahl von elektrischen Leitungen aufweist. Nach der Befestigung der Chips auf dem Leiterrahmen durch Löten oder Kleben und der elektrischen Verbindung der Chipanschlüsse mit den einzelnen Leitern durch Bonden wird die gesamte Einheit durch Umkapselung mit einem organischen Material geschützt. Lediglich die äußeren Enden der Leiter bleiben frei und dienen der späteren Verbindung der Halbleiter mit z.B. einer Leiterplatte.

Die Leiterrahmen werden aus einem elektrisch gut leitenden Material durch Stanzen oder chemisches Ätzen hergestellt. Als Grundmaterial kommen Kupfer und Kupferlegierungen sowie Eisen-Nickel-Legierungen zum Einsatz.

Bei anders gestalteten Schaltungsträgern wird auf einer ebenen Platte oder einer Folie (beide sind aus einem elektrischen Isolator oder tragen eine entsprechende Beschichtung) eine elektrische Schaltung erzeugt. Diese Schaltung verfügt über entsprechende Kontakt- und Befestigungsflächen, die der Aufnahme der Schaltungselemente dienen. Auch hier erfolgen die Verbindungen der Elemente zu dem Schaltungsträger durch Löt-, Bond- und Klebetechniken. Die Leiterplatten werden vorwiegend mit Kupfer beschichtet und mechanisch, mit Laserstrahlung oder naßchemisch strukturiert. Ferner sind verschiedene Siebdruckverfahren bekannt. Bei den vorgenannten Anwendungen erfolgt die Verbindung zwischen dem Träger und dem Schaltungselement durch Löt-, Bond- und/oder Klebetechniken. Die Oberfläche der Träger muß daher so gestaltet sein, daß diese Techniken auch bei der jeweils erforderliche Arbeitstemperatur und Arbeitsumgebung fehlerfrei anwendbar sind. Weitere Anforderungen bestehen insbesondere in der Langzeitbeständigkeit des Trägers und in der Korrosionsbeständigkeit.

Die genannten Materialien, aus denen die Träger gefertigt werden, haben den Nachteil, daß die Oberfläche von Kupfer und auf Kupfer basierenden Trägern sowie auf Eisen-Nickel basierenden Trägerwerkstoffen leicht oxidiert. Dies hat zur Folge, daß die vorgenannten Verbindungstechniken nicht mehr oder nur noch fehlerhaft durchgeführt werden können.

Um dieses Problem zu lösen, werden die Träger vielfach mit elektrochemischen Plattierungsverfahren beschichtet. Bekannt ist die galvanische Beschichtung mit Nickel. Nickel soll als Barriere die Diffusion von Kupfer an die Oberfläche und somit die Reaktion von Kupfer mit Sauerstoff oder Schwefel verhindern. Nachteiligerweise hat sich aber herausgestellt, daß galvanische Nickelschichten Poren und Korngrenzen enthalten, durch die Kupfer hindurchdiffundieren bzw. migrieren kann. Deshalb müssen relativ dicke Nickelschichten im Bereich von 5 - 10 µm aufgebracht werden. Schichten dieser Dicke stellen jedoch ein Problem bei der Formung (Biegen) der Leiter dar, da diese Risse zeigen.

Lösungen zur Herabsetzung der Dicke der Nickelschicht sind bekannt. So ist in EP 0 250 146 A1 eine dünne Palladiumschicht oder PdNi-Legierungsschicht auf der Nickelschicht offenbart. Aber auch bei dieser Metallisierung wurden weiterhin Cu-Reaktionsprodukte an der Oberfläche beobachtet, was zu einer eingeschränkten Löt- und Bondbarkeit führte.

In der US 5 561 320 wird ein Leiterrahmen beschrieben, der mit einer Pd- oder Pd/Ni-Schicht im Plattierverfahren beschichtet wird. Eine zweite Schicht wird dann aus Kupfer abgeschieden. Darauf erfolgt eine Punktplattierung (Spot-Plating) mit Silber.

Die EP 0 474 499 A2 offenbart eine Beschichtung für einen Leiterrahmen aus einer Palladium- oder Palladium-Legierungs-Schicht, die direkt oder mittels einer Zwischenschicht aus Nickel auf das Grundmaterial aufgebracht ist, gefolgt von einer Silber- oder Goldschicht. Als Palladiumlegierung wird Pd-Ni, Pd-Co, Pd-Ag oder Pd-Cu vorgeschlagen.

Die US 5 360 991 schlägt eine Mehrlagenbeschichtung vor, die aus einer Nickelschicht besteht, gefolgt von einer Palladiumschicht, einer Palladium-Nickelschicht, einer Palladiumschicht und schließlich einer Goldschicht an der Oberfläche.

Die EP 0 538 019 A2 schließlich offenbart eine Beschichtung für Leiterrahmen, die aus Eisen oder eisenhaltigen Grundmaterialien bestehen. Dabei wird zunächst eine Kupferschicht oder Kupfer-Legierungsschicht auf den Grundkörper aufgebracht. Anschließend erfolgt die Beschichtung mit einer Nikkelschicht, Kobaltschicht oder Ni-Co-Legierungsschicht und einer Deckschicht-aus Palladium, Gold oder Silber.

Die Herstellung der vorgenannten Beschichtungen erfolgt überwiegend durch Anwendung von elektrochemischen Verfahren.

Die bisher bekannten Träger haben den erheblichen Nachteil, daß die Beschichtungen die Diffusion/Migration der leicht oxidierenden Metalle nur unzureichend verhindern. Dies wird insbesondere bei steigenden Anforderungen an die Temperaturbeständigkeit und Verarbeitbarkeit der Halbleiterbauelemente ein Problem. Ein weiterer schwerwiegender Nachteil besteht darin, daß die bekannten Beschichtungen sehr teure Edelmetalle in erheblichem Umfang enthalten und somit kostenintensiv sind. Verfahrenstechnisch besteht ein weiterer Nachteil darin, daß die bekannten Schichten Korngrenzendiffusionen aufgrund der "lockeren" Morphologie und zum Teil vorliegenden Wachstumsfehlstellen nur ungenügend unterbinden. Dies ist insbesondere bei für Leiterrahmen ausschließlich angewendeten elektrochemischen Verfahren der Fall. Erschwerend kommt hinzu, daß die damit hergestellten Schichten inhomogen sind und sehr dick sein müssen, um eine Barrierewirkung zu erzielen. Dies führt zu langen Prozeßzeiten und teuren Beschichtungen.

Sehr nachteilig erweist sich bei den bekannten Trägern auch der Umstand, daß vielfach eine lokale Beschichtung aufgebracht werden muß, da die Beschichtungen nicht die geforderte multifunktionale Eigenschaft besitzen, die in gleicher Weise das Bonden, Löten oder Kleben sowie einen langfristigen Korrosionsschutz ermöglicht.

Der vorliegenden Erfindung liegt daher die Aufgabe zugrunde, einen Träger für elektrische Schaltungselemente, der für den elektrischen Anschluß der Schaltungselemente durch Löten, Bonden oder Kleben aus einem strukturierten Grundkörper besteht oder mit Strukturen beschichtet ist, die aus leicht oxidierenden Metallen bestehen, welche einen mehrschichtigen, elektrisch leitenden Überzug aufweisen, der an der äußeren Oberfläche inert ist und eine Migration der leicht oxidierenden Metalle unterbindet sowie gut Löt-, Bond- oder Klebeeigenschaften aufweist, dahingehend zu verbessern, daß eine multifunktionale Oberfläche für Bond-, Löt- und Klebverbindungen geschaffen wird, die kostengünstig hergestellt werden kann und die über hervorragende Barriere- und Korrosionsschutzwirkungen auch bei Anwendung erhöhter Temperaturen und ausgedehnter Lager- und Betriebszeiten verfügt.

Diese Aufgabe wird erfindungsgemäß gelöst durch einen Träger mit den Merkmalen des Anspruchs 1. Vorteilhafte Weiterbildungen des erfindungsgemäßen Trägers sowie ein Verfahren zu dessen Herstellung ergeben sich aus den Unteransprüchen.

Als strukturierter Grundkörper wird zweckmäßig ein Leiterrahmen für Halbleiterchips verwendet, der durch Stanzen, Laserschneiden oder Ätzen geformt wurde und aus Kupfer-Kupferlegierungen, Eisen-Nickel-Legierungen oder auch anderen Metallen besteht. Nicht strukturierte Träger sind üblicherweise aus ebenen Platte oder einer flexiblen Folie gebildet, die mit einer Standardmetallisierung versehen sind, welche aus einer Haft- und Diffusionsschicht sowie einer Leiterebene aus Kupfer oder auf Kupfer basierenden mehrkomponentigen Schichten besteht.

Der strukturierte Grundkörper sowie der nichtstrukturierte, jedoch eine strukturierte Standardmetallisierung aufweisende Träger sind mit einem mehrschichtigen, elektrisch leitenden Überzug versehen, der erfindungsgemäß wie folgt zusammengesetzt ist:
a) eine erste ein- oder mehrlagige Schicht, die als Haft- oder Barriereschicht wirkt,
b) eine zweite ein- oder mehrlagige Schicht, die als Funktionsschicht für das Löten, Bonden oder Kleben dient, und
c) eine dritte ein- oder mehrlagige Schicht an der äußeren Oberfläche des Überzugs, welche inerte Eigenschaften und eine hohe Oberflächenenergie besitzt.

Hierbei kann die erste Schicht zwischen dem Grundkörper bzw. der Standardmetallisierung und der zweiten Schicht, jedoch auch zwischen der zweiten und der dritten Schicht angeordnet sein. Bevorzugt ist die erste Schicht jedoch in Dickenrichtung geteilt, wobei der erste Teil zwischen dem Grundkörper und der Standardmetallisierung und der zweite Teil zwischen der zweiten und der dritten Schicht angeordnet sind.

Ein wesentlicher Vorteil des erfindungsgemäßen Überzugs besteht darin, daß trotz der erzielten Wirkungen im Sinne der Aufgabenlösung extrem dünne Schichten möglich sind und das Verfahren kostengünstig durchgeführt werden kann.

Die Erfindung wird im Folgenden anhand von in den Figuren dargestellten Ausführungsbeispielen näher erläutert. Es zeigen:
- Fig. 1: den Schichtaufbau eines Überzugs, und
- Fig. 2: den Aufbau einer mehrlagigen zweiten Schicht.

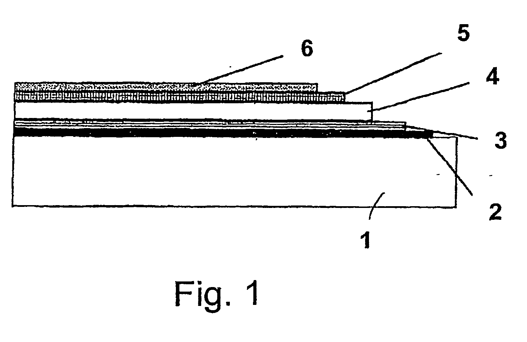

Gemäß Fig. 1 weist ein strukturierter Grundkörper 1, der beispielsweise aus Kupfer, einer Kupferlegierung oder einer Nickel-Eisen-Legierung besteht, eine ionengereinigte Oberfläche 2 auf. Diese wird dadurch erhalten, daß der Grundkörper 1 auf dieser Seite zunächst unter Verwendung tensidischer Verfahren naß gereinigt und dann in einem Vakuumprozeß durch Ionenätzung einer intensiven atomaren Reinigung unterzogen wird. Dadurch wird sichergestellt, daß - unabhängig von der bisherigen Behandlung des Trägers - eine vollständig saubere und oxidfreie Oberfläche vorliegt, auf die die einzelnen Schichten des Überzugs aufgebracht werden können.

Der sich an die Oberfläche 2 anschließende erste Teil 3 der ersten Schicht des Überzugs hat die Funktion, die Diffusion von Kupfer oder eines anderen Materials des Grundkörpers 1 an die Oberfläche zu verhindern und gleichzeitig die erforderlich Haftung und Verformung der Schichten sicherzustellen bei ebenfalls geforderter Temperatur- und Langzeitstabilität. Dies wird durch eine dünne Schicht aus einem Material ermöglicht, das reaktiv, z.B. mittels eines Magnetron-Sputterverfahrens hergestellt wird. Vorteilhafterweise besteht die erste Schicht aus gradierten Ti-TiN-Ti-Lagen oder aus einer Einzellage aus TiN. Dabei wird unter TiN nicht nur die stöchiometrische Phase verstanden, sondern es können auch Subnitride zur Anwendung kommen. Der Stickstoffanteil in Atomprozent beträgt 0 - 60%. Die Schicht bzw. deren einzelne Lagen wird vorzugsweise unter Anwendung einer elektrischen Substratvorspannung (Biasverfahren) hergestellt. Diese Verfahren erlaubt die-Herstellung sehr dichter Schichten mit guter Barrierewirkung. Die TiN-Schicht als Einzelschicht zeigte jedoch schlechte Bondeigenschaften und ist nicht lötbar (mit für Leiterrahmen relevante Bedingungen). Überraschenderweise wurde dagegen gefunden, daß die Schicht aus Ti-TiN-Ti-Lagen sehr gut löt- und bondbar ist. Die Schichtdicke der erste Schicht liegt zwischen 0,5 nm und 100 nm. In Einzelfällen können auch größere Dicken verwendet werden.

Alternative Schichtmaterialien für die erste Schicht sind: Wolframnitrid als Einzellage oder mit den Lagen W-WN-W, Tantalnitrid (auch Ta-TaN-Ta), sowie Mischungen (z.B. TiW-TiWN-TiW oder als Mehrfachschicht Ti-W-TiN-WN-Ti-W). Weitere Materialien sind: NiCr mit einem Nickelanteil von 1 - 100 Atomprozent, NiCrN, Molibdän, MoN, FeNi und Kombinationen aus diesen. Weitere alternative Schichten bestehen aus Zr, Nb, Co, Zn, Sn, Ni und deren nitridischen Phasen.

Die zweite Schicht 4 besteht bestimmungsgemäß aus gut lötbaren und bondbaren Materialien. Beispielsweise wird hier eine auf Nickel oder Silber basierende Schicht, eine Einzellage aus einem dieser Materialien oder eine Mehrlagenschicht aus beiden (Ni-Ag-Ni-...) verwendet. Die zweite Schicht wird vorteilhafterweise ebenfalls unter Anwendung von Biasverfahren aufgebracht. Auch eignen sich gradierte Übergänge. Alternativ können andere Materialien mit guten Löt- und Bondeigenschaften eingesetzt werden. Der Schichtdikkenbereich für die zweite Schicht liegt zwischen 1 nm und 10 µm, bevorzugt zwischen 50 nm und 2 µm.

Alternativen für die genannten Materialien Ni und Ag sind Sn, Zn und Co.

In dem in Fig. 1 gezeigten Beispiel besteht die erste Schicht aus dem zwischen dem Grundkörper 1 und der zweiten Schicht 4 angeordneten ersten Teil 3 und einem zwischen der zweiten Schicht 4 und der dritten Schicht 6 angeordneten zweiten Teil 5. Dieser zweite Teil 5 der ersten Schicht dient der Stabilisierung der extrem dünnen inerten dritten Schicht 6 (Deckschicht). Sie hat die Aufgabe, Diffusionen zwischen der zweiten Schicht 4 und der dritten Schicht 6 zu verhindern, sowie die Barriere zwischen der dritten Schicht 6 und dem Grundkörper 1 zu erhöhen. Der zweite Teil 5 wird wie der erste Teil 3 der ersten Schicht hergestellt, muß aber nicht die gleiche Folge der einzelnen Lagen besitzen. Der bevorzugte Dickenbereich des zweiten Teils 5 liegt bei 5 nm - 50 nm.

Die dritte Schicht 6 dient der Bereitstellung einer stabilen, oxidfreien bzw. thermisch befreibaren Oberfläche. Hier hat sich gezeigt, daß eine sehr dünne Schicht aus Gold die geforderten Eigenschaften erfüllt. Auch diese Schicht kann vorteilhafterweise mit einem Biasverfahren hergestellt werden.

Alternative Schichten sind mehrlagige Schichten aus Silber und Gold sowie Gold-Silber-Mischlagen mit einem Goldanteil von 1 - 100 Atomprozent. Weitere geeignete Materialien sind Platin und Palladium. Die Dicke der dritten Schicht 6 beträgt vorzugsweise 1 nm bis 500 nm.

Die verschiedenen Schichten bzw. deren einzelne Lagen werden hinsichtlich ihrer Härte, Morphologie, Schichtstruktur und Topographie durch entsprechende Wahl der Beschichtungsparameter (Substratvorspannung, Größe der Vorspannung, Temperatur, Sputtergasdruck usw.) eingestellt.

Die Beschichtung des Grundkörpers 1 kann einseitig oder beidseitig erfolgen. Dabei können auf die Vorder- und Rückseite auch unterschiedliche Schichten aufgebracht werden. Beispielsweise kann die Rückseite nur mit der ersten Schicht belegt und somit nur ein Korrosionsschutz erhalten werden.

Weiterhin kann der Überzug auch lokal aufgebracht werden. Dies kann z.B. durch subtraktive (Ätz-) Verfahren oder mit Hilfe von mechanischen Abdeckungen während der Beschichtung erfolgen.

Nachfolge wird ein beispielhaftes Verfahren zur Herstellung gestanzter Kupfer-Leiterrahmen mit den erfindungsgemäßen Merkmalen beschrieben. Die Grundkörper sind nicht vereinzelt und in Form eines mehrere Meter langen Bandes vorhanden, das auf eine Rolle aufgewickelt ist.

Der erste Schritt dient der Reinigung der gestanzten Leiterrahmen. Hierzu wird eine Naßreinigung in tensidischen Bädern durchgeführt. Dies erfolgt im Durchlaufverfahren von Rolle zu Rolle.

Die gereinigten Bänder werden dann eine PVD-Durchlaufanlage mit Schleusenkammern eingebracht. Das Band wird mit einer vorgewählten Geschwindigkeit an den im Folgenden beschriebenen Stationen vorbeigeführt. Das Beschichten erfolgt durch Sputtern im Vakuum bei 0,1 Pa bis ca. 2 Pa. Es können jedoch auch Stationen eingesetzt werden, die mit Hochrate-Aufdampfquellen ausgerüstet sind, sowie Stationen mit Gasfluß-Sputterquellen. Die Anlage kann aus einer Vakuumkammer oder aus mehreren unterteilten Kammern bestehen.

Die Herstellung der Leiterrahmen erfolgt, indem zunächst im Vakuum ein Ionenätzprozeß durchgeführt wird. Hierzu wird das Band mit einer Gleichstromquelle verbunden. Das Plasma wird durch geeignete Magnetfelder lokal unterstützt. Als Ätzgas dient Argon; es können jedoch auch andere Ätzgase zur Anwendung kommen. Für die Ionenreinigung können auch eine vom Band getrennte Elektrode oder andere bekannte Ionenquellen eingesetzt werden.

Nach der Ionenreinigung wird das Band an verschiedenen Magnetron-Sputterquellen vorbeigeführt. Dabei können auch zwei einander gegenüberstehende Quellen verwendet werden, die gleichzeitig die Vorder- und Rückseite der Bänder beschichten. Die Sputterquellen bestehen aus Rechteckquellen mit einem Längen/Breiten-Verhältnis von 2 - 20. Die jeweils erforderliche Schichtdicke wird über die Targetlänge, den Abstand, die Bandgeschwindigkeit und die Leistungsdichte gesteuert.

Entsprechend der vorgeschriebenen Beschichtungsfolge wird das Band an verschiedenen Sputterquellen vorbeigeführt und nacheinander mit den einzelnen Schichten bzw. Lagen belegt. Reaktive Prozesse werden in separaten Kammern durchgeführt. Auf diese Weise lassen sich z.B. gradierte Schichten aus Ti mit zunehmendem N-Anteil oder TiN-Schichten herstellen.

Nach dem Aufbringen der dritten Schicht wird das Band einer Schleuse zugeführt und dort wieder auf eine Rolle aufgewickelt.

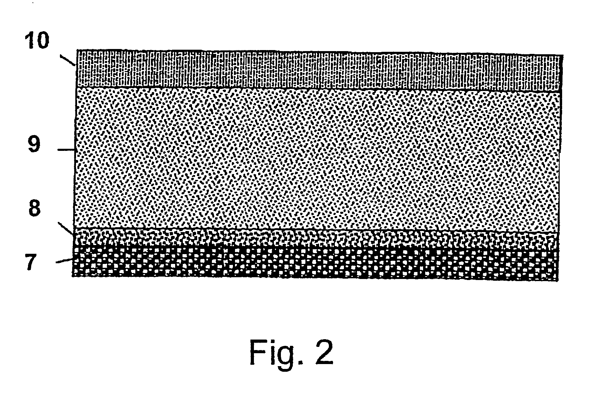

Fig. 2 zeigt den beispielhaften Aufbau einer zweiten Schicht mit unterschiedlicher Morphologie des Schichtmaterials. An die erste Schicht angrenzend befindet sich eine Mischzone 7, in der zur besseren Haftung die Materialien der ersten und zweiten Schicht gemischt sind. Die Materialien der zweiten Schicht sind beispielsweise Nickel und Silber. An die Mischzone 7 schließt sich eine gradierte Lage 8 an, in der sich das Verhältnis von Nickel zu Silber mit zunehmendem Abstand von der Mischzone 7 ändert. Über der gradierten Lage 8 folgt eine feinkristalline Lage 9 mit über die Dicke unveränderter Zusammensetzung. Die gewünschte Morphologie wird beispielsweise durch reduzierten Sputter-Gasdruck und/oder leichten Ionenbeschuß während des Beschichtungsvorgangs erhalten. Schließlich folgt eine sehr dichte, quasi amorphe Lage 10 aus beispielsweise demselben Material, welche dadurch erhalten werden kann, daß die Vorspannung (Biαs) erhöht und/oder der Ionenbeschuß verstärkt wird. In dieser Lage 10 existieren praktisch keine Korngrenzenbereiche mehr.

## Patentansprüche

1. Träger für elektrische Schaltungselemente, der für den elektrischen Anschluss der Schaltungselemente durch Löten, Bonden oder Kleben aus einem strukturierten Grundkörper besteht oder mit Strukturen beschichtet ist, die aus leicht oxidierenden Metallen bestehen, welche einen mehrschichtigen, elektrisch leitenden Überzug aufweisen, der die folgende Zusammensetzung aufweist:
a) eine erste ein- oder mehrlagige Schicht, die als Haft- und Barriereschicht wirkt,
b) eine zweite ein- oder mehrlagige Schicht, die als Funktionsschicht für das Löten, Bonden oder Kleben dient, und
c) eine dritte ein- oder mehrlagige Schicht an der äußeren Oberfläche des Überzugs, welche inerte Eigenschaften und eine hohe Oberflächenenergie besitzt,
**dadurch gekennzeichnet, dass** die Schichten des Überzugs mittels eines PVD- und/oder CVD-Verfahrens aufgebracht sind.

2. Träger nach Anspruch 1, **dadurch gekennzeichnet, daß** die erste Schicht zwischen den oxidierenden Metallen und der zweiten Schicht angeordnet ist.

3. Träger nach Anspruch 1, **dadurch gekennzeichnet, daß** die erste Schicht zwischen der zweiten und der dritten Schicht angeordnet ist.

4. Träger nach Anspruch 1, **dadurch gekennzeichnet, daß** die erste Schicht in Dickenrichtung geteilt ist und sich der erste Teil zwischen den oxidierenden Metallen und der zweiten Schicht und der zweite Teil zwischen der zweiten und der dritten Schicht befinden.

5. Träger nach einem der Ansprüche 1 bis 4, **dadurch gekennzeichnet, daß** die erste Schicht aus einer Einzellage aus TiN oder aus mehreren Lagen aus Ti und TiN besteht.

6. Träger nach Anspruch 5, **dadurch gekennzeichnet, daß** der Stickstoffanteil im TiN bis 60 Atom% beträgt.

7. Träger nach einem der Ansprüche 1 bis 4, **dadurch gekennzeichnet, daß** die erste Schicht aus einer Einzellage aus Wolframnitrid oder Tantalnitrid oder aus mehreren Lagen aus Wolfram und Wolframnitrid oder aus Tantal und Tantalnitrid besteht.

8. Träger nach einem der Ansprüche 1 bis 7, **dadurch gekennzeichnet, daß** die mehreren Lagen der ersten Schicht gradierte Lagen sind.

9. Träger nach einem der Ansprüche 1 bis 8, **dadurch gekennzeichnet, daß** die Dicke der ersten Schicht oder des ersten Teils der ersten Schicht 0,5 nm bis 100 nm beträgt.

10. Träger nach einem der Ansprüche 4 bis 9, **dadurch gekennzeichnet, daß** der zweite Teil der ersten Schicht eine Dicke im Bereich von 5 nm bis 50 nm aufweist.

11. Träger nach einem der Ansprüche 1 bis 10, **dadurch gekennzeichnet, daß** die zweite Schicht aus einer auf Ni oder Ag basierenden Einzellage oder mehreren Lagen dieser Materialien besteht.

12. Träger nach einem der Ansprüche 1 bis 11, **dadurch gekennzeichnet, daß** die zweite Schicht eine Dicke im Bereich von 1 nm bis 10 µm aufweist.

13. Träger nach Anspruch 12, **dadurch gekennzeichnet, daß** die zweite Schicht eine Dicke im Bereich von 50 nm bis 2 µm aufweist.

14. Träger nach einem der Ansprüche 1 bis 13, **dadurch gekennzeichnet, daß** die dritte Schicht aus einer Einzellage aus Au, Ag, Pt oder Pd besteht.

15. Träger nach einem der Ansprüche 1 bis 13, **dadurch gekennzeichnet, daß** die dritte Schicht aus mehreren Lagen aus Au, Ag, Pt oder Pd sowie Legierungen dieser Materialien besteht.

16. Träger nach einem der Ansprüche 1 bis 15, **dadurch gekennzeichnet, daß** die dritte Schicht eine Dicke im Bereich von 1 nm bis 500 nm aufweist.

17. Träger nach einem der Ansprüche 1 bis 16, **dadurch gekennzeichnet, daß** der Träger ein Leiterrahmen (Lead Frame) für Halbleiterchips ist.

18. Träger nach einem der Ansprüche 1 bis 16, **dadurch gekennzeichnet, daß** der Träger eine mit Leiterbahnen versehene Schaltungsplatte ist.

19. Verfahren zum Herstellen eines Trägers nach einem der Ansprüche 1 bis 18, **dadurch gekennzeichnet, daß** die Schichten des Überzugs mittels eines PVD- und/oder eines CVD-Verfahrens aufgebracht werden.

20. Verfahren nach Anspruch 19, **dadurch gekennzeichnet, daß** zumindest ein Teil der Schichten des Überzugs in einer PVD-Durchlaufanlage mit Schleusenkammern für die einzelnen Beschichtungsmaterialien aufgebracht wird.

21. Verfahren nach Anspruch 19 oder 20, **dadurch gekennzeichnet, daß** als Quellen für die Überzugsmaterialien Hochrate-Aufdampfquellen, Magnetron-Sputter-Quellen und/oder Gas-Fluß-Sputter-Quellen verwendet werden.

22. Verfahren nach einem der Ansprüche 19 bis 21, **dadurch gekennzeichnet, daß** der Träger vor dem Aufbringen des Überzugs zumindest auf der mit dem Überzug zu versehenen Seite einer Naßreinigung in einem tensidischen Bad unterzogen wird.

23. Verfahren nach einem der Ansprüche 19 bis 22, **dadurch gekennzeichnet, daß** der Träger vor dem Aufbringen des Überzugs zumindest auf der mit dem Überzug zu versehenden Seite in einem Vakuumprozeß durch Plasma und/oder Ionenätzung gereinigt wird.

24. Verfahren nach einem der Ansprüche 19 bis 23, **dadurch gekennzeichnet, daß** die Plasma- und/oder Ionenätzung mittels zusätzlicher Elektroden erfolgt oder Ionenquellen hierfür eingesetzt werden.

## Claims

1. Support for electrical circuit elements which consists of a structured base for the electrical connection of the circuit elements by soldering, bonding or adhesion, or which is coated with structures that are made of metals which oxidise readily and which have a multilayered, electrically conductive coating that is made up as follows:
a a first single- or multi-part layer which acts as an adhesive layer and barrier layer,
b a second single- or multi-part layer which acts as a function layer for the soldering, bonding or adhesion processes, and
c a third single- or multi-part layer on the outer surface of the coating which has inert properties and a high surface energy,
**characterised in that**
the layers of the coating are applied by means of a PVD and/or CVD process.

2. Support as in claim 1,
**characterised in that**
the first layer is positioned between the oxidising metals and the second layer.

3. Support as in claim 1,
**characterised in that**
the first layer is positioned between the second and third layers.

4. Support as in claim 1,
**characterised in that**
the first layer is divided across its thickness, and the first part is located between the oxidising metals and the second layer, and the second part is located between the second and the third layers.

5. Support as in one of claims 1 to 4,
**characterised in that**
the first layer consists of a single stratum of TiN or of several strata of Ti and TiN.

6. Support as in claim 5,
**characterised in that**
the nitrogen part in the TiN is up to 60 atom %.

7. Support as in one of claims 1 to 4,
**characterised in that**
the first layer consists of a single stratum of tungsten nitride or tantalum nitride or of several strata of tungsten and tungsten nitride or of tantalum and tantalum nitride.

8. Support as in one of claims 1 to 7,
**characterised in that**
the several strata of the first layer are graduated strata.

9. Support as in one of claims 1 to 8,
**characterised in that**
the thickness of the first layer or of the first part of the first layer is between 0.5 nm and 100 nm.

10. Support as in one of claims 4 to 9,
**characterised in that**
the second part of the first layer has a thickness of between 5 nm and 50 nm.

11. Support as in one of claims 1 to 10,
**characterised in that**
the second layer consists of a single stratum based on Ni or Ag, or several strata of these materials.

12. Support as in one of claims 1 to 11,
**characterised in that**
the second layer has a thickness of between 1 nm and 10 µm.

13. Support as in claim 12,
**characterised in that**
the second layer has a thickness of between 50 nm and 2 µm.

14. Support as in one of claims 1 to 13,
**characterised in that**
the third layer consists of a single stratum of Au, Ag, Pt or Pd.

15. Support as in one of claims 1 to 13,
**characterised in that**
the third layer consists of several strata of Au, Ag, Pt or Pd or alloys of these materials.

16. Support as in one of claims 1 to 15,
**characterised in that**
the third layer has a thickness of between 1 nm and 500 nm.

17. Support as in one of claims 1 to 15,
**characterised in that**
the support is a lead frame for semiconductor chips.

18. Support as in one of claims 1 to 16,
**characterised in that**
the support is a circuit card with track conductors.

19. Method of manufacturing a support as in one of claims 1 to 18,
**characterised in that**
the layers of the coating are applied by means of a PVD and/or CVD process.

20. Method as in claim 19,
**characterised in that**
at least some of the layers of the coating are applied in a continuous PVD facility with lock chambers for the individual coating materials.

21. Method as in claim 19 or 20,
**characterised in that**
high-rate vapour deposition sources, magnetron sputter sources and/or gas flow sputter sources are used as sources of the coating materials.

22. Method as in one of claims 19 to 21,
**characterised in that**
the support is subjected, prior to the application of the coating, at least on the side on to which the coating is to be placed, to a wet cleaning process in a surfactant bath.

23. Method as in one of claims 19 to 22,
**characterised in that**
the support is cleaned, prior to the application of the coating, at least on the side on to which the coating is to be placed, in a vacuum process using plasma and/or ion etching.

24. Method as in one of claims 19 to 23,
**characterised in that**
the plasma and/or ion etching process is carried out using additional electrodes, or ion guns are used for this purpose.

## Revendications

1. Support pour éléments de circuits électriques, qui se compose, pour le raccordement électrique des éléments de circuit par brasage, fixation ou collage, d'un corps de base structurel ou qui est recouvert de structures, qui se composent de métaux qui s'oxydent aisément et qui comportent un revêtement électriquement conducteur formé de plusieurs couches et qui présente la composition suivante:
a) une première couche formée d'une seule nappe ou de plusieurs nappes et qui agit en tant que couche d'adhérence et couche formant barrière,
b) une seconde couche formée d'une ou de plusieurs nappes et qui est utilisée en tant que couche fonctionnelle pour le brasage, la fixation ou le collage, et
c) une troisième couche formée d'une ou de plusieurs nappes sur la surface extérieure du revêtement, qui possède des caractéristiques inertes et une énergie de surface élevée,
**caractérisé en ce que** les couches du revêtement sont déposées à l'aide d'un procédé PVD et/ou d'un procédé CVD.

2. Support selon la revendication 1, **caractérisé en ce que** la première couche est disposée entre les métaux qui s'oxydent et la deuxième couche.

3. Support selon la revendication 1, **caractérisé en ce que** la première couche est disposée entre les seconde et troisième couches.

4. Support selon la revendication 1, **caractérisé en ce que** la première couche est divisée dans le sens de l'épaisseur et que la première partie est située entre les métaux qui s'oxydent et la seconde couche, et que la seconde partie située entre les entre les seconde et troisième couches.

5. Support selon l'une des revendications 1 à 4, **caractérisé en ce que** la première couche est formée par une nappe individuelle formée de TiN ou de plusieurs nappes formées de Ti et TiN.

6. Support selon la revendication 5, **caractérisé en ce que** le pourcentage d'azote dans le TiN est égal jusqu'à 60 % atomiques.

7. Support selon l'une des revendications 1 à 4, **caractérisé en ce que** la première couche est formée par une nappe individuelle de nitrure de tungstène ou de nitrure de tantale ou par plusieurs nappes formées de tungstène et de nitrure de tungstène ou de tantale et de nitrure de tantale.

8. Support selon l'une des revendications 1 à 7, **caractérisé en ce que** la pluralité de nappes de la première couche sont des nappes gradées.

9. Support selon l'une des revendications 1 à 8, **caractérisé en ce que** l'épaisseur de la première couche ou de la première partie de la première couche est comprise entre 0,5 nm et 100 nm.

10. Support selon l'une des revendications 4 à 9, **caractérisé en ce que** la seconde partie de la première couche possède une épaisseur dans la gamme de 5 nm à 50 nm.

11. Support selon l'une des revendications 1 à 10, **caractérisé en ce que** la seconde couche se compose d'une nappe individuelle basée sur du Ni ou du Ag ou de plusieurs nappes de ces matériaux.

12. Support selon l'une des revendications 1 à 11, **caractérisé en ce que** la seconde couche possède une épaisseur dans la gamme de 1 nm à 10 µm.

13. Support selon la revendication 12, **caractérisé en ce que** la seconde couche possède une épaisseur dans la gamme de 50 nm à 2 µm.

14. Support selon l'une des revendications 1 à 13, **caractérisé en ce que** la troisième couche se compose d'une nappe individuelle de Au, Ag, Pt ou Pd.

15. Support selon l'une des revendications 1 à 13, **caractérisé en ce que** la troisième couche se compose de plusieurs nappes de Au, Ag, Pt ou Pd ainsi que des alliages de ces matériaux.

16. Support selon l'une des revendications 1 à 15, **caractérisé en ce que** la troisième couche possède une épaisseur dans la gamme de 1 nm à 500 nm.

17. Support selon l'une des revendications 1 à 16, **caractérisé en ce que** le support est un cadre conducteur (Lead Frame) pour des plaquettes semiconductrices.

18. Support selon l'une des revendications 1 à 16, **caractérisé en ce que** le support est une plaque de circuits comportant des voies conductrices.

19. Procédé pour la fabrication d'un support selon l'une des revendications 1 à 18, **caractérisé en ce que** les couches du revêtement sont déposées à l'aide d'un procédé PVC et/ou d'un procédé CVD.

20. Procédé selon la revendication 19, **caractérisé en ce qu'**au moins une partie des couches du revêtement est déposée dans une installation PVD continue avec des chambres formant sas pour les différents matériaux de revêtement.

21. Procédé selon la revendication 19 ou 20, **caractérisé en ce qu'**on utilise comme sources pour les matériaux de revêtement, des sources de dépôt par évaporation à haut débit, des sources de pulvérisation à magnétron et/ou des sources de pulvérisation à flux de gaz.

22. Procédé selon l'une des revendications 19 à 21, **caractérisé en ce que** le support est soumis avant le dépôt du revêtement, au moins sur la face devant être pourvue du revêtement, à un nettoyage par voie humide dans un bain d'agent tensioactif.

23. Procédé selon l'une des revendications 19 à 22, **caractérisé en ce qu'**on nettoie le support avant l'application du revêtement au moins sur le côté, devant être équipé du revêtement, dans un processus sous vide au moyen d'un plasma et/ou d'une attaque ionique.

24. Procédé selon l'une des revendications 19 à 23, **caractérisé en ce que** l'attaque plasmatique et/ou l'attaque ionique s'effectuent à l'aide d'électrodes supplémentaires, ou qu'on utilise des sources d'ions à cet effet.
